Europäisches Patentamt

European Patent Office

Office européen des brevets

(19)

(11) Numéro de publication: **0 147 245**
**B1**

# FASCICULE DE BREVET EUROPÉEN

(12)

(45) Date de publication du fascicule du brevet:
14.10.87

(51) Int. Cl.⁴: **G 01 R 31/02**, G 01 R 31/28

(21) Numéro de dépôt: **84401009.0**

(22) Date de dépôt: **17.05.84**

(54) **Dispositif et procédé de contrôle de continuité des circuits imprimés.**

(30) Priorité: **28.12.83 FR 8321055**

(43) Date de publication de la demande:
**03.07.85 Bulletin 85/27**

(45) Mention de la délivrance du brevet:
**14.10.87 Bulletin 87/42**

(84) Etats contractants désignés:
**BE CH DE FR GB IT LI LU NL SE**

(56) Documents cité:
**US-A-4 056 773**

**IBM TECHNICAL DISCLOSURE BULLETIN , vol. 22, no. 7, décembre 1979, pages 2704-2705, New York, US; L.M. ZOBNIW: "Orthogonal shorts detector"**
**IBM TECHNICAL DISCLOSURE BULLETIN, vol. 26, no. 5, octobre 1983, pages 2594-2595, New York, US; A.H. KUMAR et al.: "Liquid crystal electrical continuity tester"**
**PATENTS ABSTRACTS OF JAPAN, vol. 7, no. 15 (P-169) 1160 , 21 janvier 1983**
**IBM TECHNICAL DISCLOSURE BULLETIN, vol. 12, no. 5, octobre 1969, pages 655-656, New York, US; P.M. DEGROAT et al.: "Finding shorts in printed circuit boards"**

(73) Titulaire: **CROUZET, 128, Avenue de la République, F-75011 Paris (FR)**

(72) Inventeur: **Morille, Robert, 25, rue Jules Védrines, F-26027 Valence Cédex (Drôme) (FR)**
Inventeur: **Saroul, Jacques, 25, rue Jules Védrines, F-26027 Valence Cédex (Drôme) (FR)**

(74) Mandataire: **Bloch, Robert, 6, rue du Faubourg Saint- Honoré, F-75008 Paris (FR)**

LIBER, STOCKHOLM 1987

## Description

La présente invention concerne les dispositifs de contrôle qualitatif des circuits imprimés complexes et notamment de ceux obtenus en technologie industrielle dite "hybride"; ces circuits, généralement très compacts, étant constitués de multiples couches superposées de matériau isolant comportant une ou plus ou moins grande densité d'éléments conducteurs ramifiés.

Dans la demande de brevet français N° 2 521 305, la demanderesse a précédemment exposé la méthode et les moyens de mise en oeuvre permettant d'effectuer le contrôle qualitatif de l'isolement galvanique qui doit normalement exister entre les différents éléments - ou "arbres" - conducteurs d'un tel type de circuits imprimés multicouches.

Tout comme le contrôle qualitatif de l'isolement, celui de la continuité est essentiellement dicté par le souci d'ordre économique visant à déceler précocement les éléments défectueux dans un processus de production dont le coût s'accroît très vite à chaque stade successif de la fabrication.

Le but de la présente invention est donc d'enseigner la mise en oeuvre d'une méthode complémentaire de la précédente permettant, grâce à des moyens analogues agences de manière spécifique, d'effectuer le contrôle qualitatif de continuité électrique que doivent normalement présenter les multiples ramifications équipotentielles de chacun des "arbres" constituant l'ensemble du réseau conducteur des circuits imprimés multicouches.

Dans cette optique, on part de la considération générale que l'ensemble E des "pastilles" métalliques accessibles sur au moins une face externe d'un circuit imprimé d'un modèle technologique déterminé est normalement constitué d'un premier sous-ensemble Ei comprenant une "pastille" et une seule appartenant à chacun des "arbres" équipotentiels du circuit imprimé à contrôler et d'un deuxième sous-ensemble Ec comprenant toutes les autres "pastilles" du circuit, avec E = Ei + Ec.

En déduction de ce fait, on peut donc tirer la conséquence que le contrôle de la continuité de l'ensemble du réseau conducteur d'un circuit imprimé équivaut à tester la qualité de la liaison électrique devant exister entre chaque "pastille" du sous-ensemble Ec appartenant à un arbre donné et la "pastille" de l'ensemble Ei appartenant au même "arbre". En d'autres termes, en supposant que toutes les "pastilles" Ei soient reliées à un conducteur commun, le contrôle qualitatif est accompli par le test de la continuité entre chacune des pastilles de l'ensemble Ec et le conducteur commun à l'ensemble Ei.

On peut noter qu'un raffinement de la méthode consiste à considérer que le sous-ensemble Ec est lui-même constitué de deux sous-ensembles tels que Ec = Eci + Ece, Ece étant le sous-ensemble constitué par toutes les "pastilles" ayant la propriété d'être des extrémités d'"arbres", la prise en compte de cette particularité permettant alors d'effectuer un test complet de continuité entre chacune des "pastilles" de Ece et le conducteur commun à Ei.

D'autres dispositifs de contrôle qualitatif de la continuité électrique des multiples ramifications équipotentielles constituant le réseau conducteur des circuits imprimés sont connus, par exemple par l'article paru dans IBM TECHNICAL DISCLOSURE BULLETIN, vol. 26, no. 5, octobre 1983, pages 2594-2595, à New York, US, par A. H. Kumar e. a., intitulé: "Liquid crystal electrical continuity tester".

Ainsi, avec les mêmes préoccupations industrielles que celles qui ont motivé la demande de brevet précitée, la présente invention a pour objet un dispositif de contrôle qualitatif de la continuité électrique du réseau conducteur des circuits imprimés multicouches de divers types et configurations- y compris les plus compacts issus de la technologie dite "hybride" - qui n'ait pas les inconvénients des systèmes connus mettant notamment en oeuvre différents jeux de palpeurs à pointes.

L'invention propose un dispositif de contrôle, économique et performant, selon la revendication 1 et un procédé de contrôle qualitatif de la continuité électrique des circuits imprimés multicouches mettant en oeuvre le dispositif revendiqué selon la revendication 6.

La portée et les caractéristiques de l'invention seront mieux comprises grâce à la description qui suit d'un exemple de réalisation, donné à titre non limitatif, en référence au dessin annexé sur lequel:

- La figure 1 représente schématiquement la coupe d'un dispositif organisé pour la mise en oeuvre d'une opération de test d'un circuit imprimé multicouches présentant deux défauts internes de continuité;

- la figure 2 représente, de façon grossie, la configuration et les dimensions relatives d'une des zones élémentaires de test de la figure 1, et

- la figure 3 représente schématiquement les faces recto et verso du circuit explorateur équipant le dispositif de la figure 1, pour permettre d'effectuer le test collectif simultané de plusieurs ramifications conductrices du circuit imprimé à contrôler.

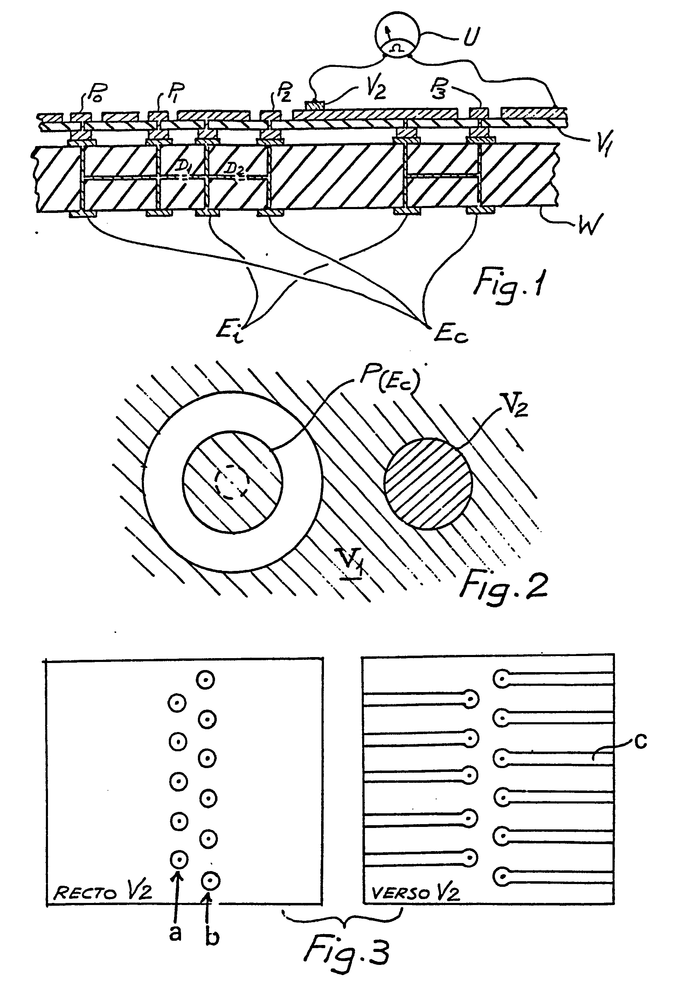

Au plan de la pratique opératoire, la méthode de contrôle de continuité, selon l'invention, est réalisée grâce à l'utilisation d'un dispositif de test organisé conformément au schéma de la figure 1.

Ainsi qu'on peut le constater, ce dispositif de test comprend un système sélectif à contacts électriques, combiné par superposition avec le spécimen (W) de circuit imprimé à tester, et composé d'un couple ($V_1$ et $V_2$) de deux circuits imprimés associés, susceptibles de déplacements relatifs coplanaires en liaison électrique avec l'appareil indicateur (U).

Le circuit $V_1$ qualifié "circuit d'interfaces spécifique" est destiné à être superposé en coïncidence géométrique rigoureuse avec les points de repères caractéristiques du spécimen W. Dans ce but, il est constitué d'un écran isolant, de préférence en matériau mince, souple, et apte à la métallisation superficielle par tous procédés photochimiques ou autres comme, par exemple, le polyimide commercialisé sous l'appellation "KAPTON" ou similaire. Ainsi, le circuit $V_1$ est un écran isolant à trous métallisés qui comporte sur une face le même ensemble de pastilles E présentes sur la face en regard du spécimen W et, sur l'autre face, un plan de masse conducteur dans lequel le premier sous-ensemble défini plus haut des pastilles Ei débouchent directement par un trou métallisé (et sont donc en liaison électrique avec le plan de masse) et le deuxième sous-ensemble des pastilles Ec qui elles sont isolées du plan de masse conducteur par un espace annulaire environnant dépourvu de métallisation.

Les pastilles Ei et Ec sont généralement de forme ronde et d'un diamètre égal à l'image de celui des pastilles du spécimen W mais il est évident que toutes autres formes adaptées à chaque cas particulier de circuit imprimé à contrôler pourraient parfaitement convenir à la mise en oeuvre de l'invention.

L'examen de la figure 1 permet de voir clairement, en coupe, la structure du spécimen W de circuit à contrôler avec son circuit spécifique $V_1$ superposé en position de test, avec le plan de masse à l'extérieur.

Si maintenant on déplace au contact de la surface extérieure du circuit $V_1$ un "patin" réalisant les conditions suivantes (figure 2):

- il est électriquement conducteur sur tout ou partie de sa superficie;
- la partie conductrice de cette superficie s'inscrit obligatoirement à l'intérieur de la zone non conductrice du plan de masse entourant chacune des pastilles de l'ensemble Ec;
- elle ne peut obligatoirement pas s'inscrire dans l'espace annulaire délimité par une pastille et le plan de masse; et si, en outre, on relie un appareil indicateur de la continuité électrique, par exemple un ohm-mètre, d'une part au plan de masse et d'autre part à la partie conductrice du patin mobile, il est clair que, pour autant qu'il demeure au contact avec le plan de masse ou une pastille coplanaire appartenant à un arbre présentant une continuité électrique de qualité normale, l'appareil indicateur ne révèlera pas de défaut (cas de la pastille $P_3$, figure 1). Mais si, par contre, l'arbre en question présente un défaut (en $D_1$ ou $D_2$, figure 1), on constatera cette discontinuité anormale seulement lorsque le patin viendra en contact coplanaire avec les pastilles $P_1$ ou $P_2$.

Toutefois, suivant le mode opératoire que l'on vient d'exposer en principe, l'exploration de toute la surface du circuit spécifique $V_1$ par un unique patin mobile tel qu'il vient d'être décrit serait une opération lente et fastidieuse. C'est pourquoi on a prévu, selon l'invention, pour opérer le test de manière collective, d'utiliser un deuxième circuit $V_2$, réalisé en matériau analogue au circuit $V_1$, comportant une pluralité de plages superficielles conductrices reliées entre faces par des trous métalliques. Chaque trou métallisé débouche, sur la face tournée vers le circuit spécifique $V_1$, dans une des multiples plages conductrices correspondant à un patin élémentaire tel que décrit plus haut et, sur la face opposée à une piste conductrice effectuant la liaison électrique avec un élément collecteur externe de l'appareil indicateur U.

On peut ainsi, par exemple, comme indiqué sur la figure 3, réaliser un circuit imprimé de test $V_2$ comportant deux alignements (a, b) de patins élémentaires, chacun d'entre eux étant relié par un trou métallisé à une piste conductrice c située sur l'autre face du circuit.

Cette piste conductrice réalise la liaison électrique avec l'appareil indicateur U pour permettre la mise en évidence des défauts de continuité affectant une ramification quelconque du réseau conducteur du spécimen à contrôler W. On peut encore aussi supprimer une des rangées (a, b) de patins alignés, l'opération de test étant alors exécutée en effectuant un déplacement aller et retour du circuit $V_2$, le mouvement dans le sens aller étant suivi d'un décalage du circuit test $V_2$ d'un demi-pas d'écartement entre les pastilles par rapport au circuit spécifique $V_1$, dans une direction perpendiculaire au mouvement dans le sens retour.

## Revendications

1. Dispositif de contrôle qualitatif de la continuité électrique des multiples ramifications équipotentielles - ou "arbres" - constituant le réseau conducteur des circuits imprimés multicouches du type conventionnel ou hybride, caractérisé par le fait qu'il comprend:
- des moyens sélectionneurs spécifiques d'un modèle-type déterminé de circuit imprimé à contrôler, agencés pour effectuer, par superposition avec ce dernier, la sélection parmi l'ensemble E des éléments conducteurs - ou "pastilles" - accessibles sur au moins une des faces externes dudit circuit imprimé à contrôler de deux sous-ensembles distincts Ei et Ec électriquement prédéfinis de manière telle que E = Ei + Ec;
- des moyens explorateurs desdits moyens sélectionneurs spécifiques pour opérer, par déplacements au contact avec ces derniers, la détection des défauts de continuité affectant le réseau conducteur du circuit imprimé à contrôler;
- des moyens indicateurs pour traduire l'état qualitatif de la continuité électrique existant dans les différentes ramifications desdits arbres.

2. Dispositif de contrôle, selon la revendication 1, caractérisé par le fait que les moyens sélectionneurs et les moyens explorateurs comprennent un écran souple en matériau isolant métallisé comportant, réparti sur chacune de ses deux faces opposées, un agencement coplanaire de plages conductrices mutuellement isolées sur une même face et interconnectées d'une face à l'autre par des trous métallisés.

3. Dispositif de contrôle, selon la revendication 2, caractérisé par le fait que l'ensemble E des plages conductrices des moyens sélectionneurs est agencé et réparti sur les deux faces opposées de l'écran de façon telle qu'à un premier sous-ensemble de plages interconnectées entre les deux faces correspond le sous-ensemble spécifique Ei comprenant une pastille et une seule par arbre du modèle-type de circuit imprimé à contrôler et qu'au deuxième sous-ensemble de plages interconnectées entre les deux faces correspond le sous-ensemble spécifique Ec comprenant toutes les autres pastilles dudit circuit imprimé à contrôler.

4. Dispositif de contrôle, selon l'une des revendications 1 à 3, caractérisé par le fait que pour permettre la séparation sélective des pastilles du circuit imprimé à tester de sorte que Ei + Ec = E, on réalise l'agencement des plages conductrices des moyens sélectionneurs de telle façon que toutes les pastilles appartenant à Ei soient électriquement reliées à une plage conductrice commune et que toutes les pastilles appartenant à Ec soient électriquement isolées de ladite plage conductrice commune par un espace annulaire de largeur constante telle qu'un patin conducteur élémentaire ($V_2$), appartenant auxdits moyens explorateurs et de forme circulaire, ne puisse s'y inscrire entièrement.

5. Dispositif de contrôle, selon l'une des revendications 1 à 4, caractérisé par le fait que pour permettre l'exploration collective de la face externe des moyens sélectionneurs, on réalise un circuit de test mobile ($V_2$) comportant une ou plusieurs rangées (a, b) de patins élémentaires dont la surface conductrice s'inscrit nécessairement dans la surface délimitée par le bord extérieur de la surface isolante entourant chacune des pastilles de l'ensemble Ec et ne peut s'inscrire entièrement dans la surface comprise entre le bord extérieur de ladite surface isolante et le bord extérieur de ladite pastille correspondante.

6. Procédé de contrôle qualitatif de la continuité électrique des circuits imprimés multicouches, mettant en oeuvre le dispositif des revendications 1 à 5 et caractérisé en ce qu'il consiste à effectuer,

- la mise en contact par superposition du circuit imprimé à tester et de ses moyens sélectionneurs spécifiques;

- le déplacement coplanaire des moyens explorateurs sur la face externe desdits moyens sélectionneurs spécifiques afin de déceler les défauts de continuité entre chacun des patins élémentaires de l'un et le plan conducteur commun de l'autre.

## Patentansprüche

1. Vorrichtung zur qualitativen Prüfung der elektrischen Kontinuität von auf gleichem Potential liegenden Vielfachverzweigungen - oder "Bäumen" -, die das Leiternetz von gedruckten Mehrschichtschaltkreisen vom konventionellen oder Hybrid-Typ bilden, dadurch gekennzeichnet, daß sie aufweist:

-spezifische Auswahlmittel für einen vorgegebenen Mustertyp des zu prüfenden gedruckten Schaltkreises, die so ausgebildet sind, daß sie durch Auflegen auf den Schaltkreis die Auswahl von zwei unterschiedlichen Untergruppen Ei und Ec aus einer Gruppe E von Leiterelementen - oder "Plättchen" - bewirken, welche an mindestens einer der Aussenseiten des zu prüfenden Schaltkreises zugänglich sind, wobei die Untergruppen Ei und Ec so elektrisch festgelegt sind, daß gilt: E = Ei + Ec;

-Abtastmittel für die besagten spezifischen Auswahlmittel, welche durch Verschiebung im Kontakt mit letzteren das Auffinden von Fehlern in der Kontinuität bewirken, die das Leiternetz des zu prüfenden gedruckten Schaltkreises beeinflussen;

-Anzeigemittel zur Umseszung des qualitativen Zustandes der elektrischen Kontinuität, der in den verschiedenen Verzweigungen der besagten Bäume existiert.

2. Vorrichtung zur Prüfung nach Anspruch 1, dadurch gekennzeichnet, daß die Auswahlmittel und die Abtastmittel einen flexiblen Schirm aus metallisiertem Isoliermaterial enthalten, welcher verteilt auf jeder seiner beiden einander gegenüberliegenden Seiten eine wechselseitige coplanare Anordnung von leitenden, auf der gleichen Seite voneinander isolierten und von einer Seite zur anderen durch metallisierte Öffnungen miteinander verbundenen Bereichen aufweist.

3. Vorrichtung zur Prüfung nach Anspruch 2, dadurch gekennzeichnet, daß die Gruppe E der leitenden Bereiche der Auswahlmittel so auf den beiden einander gegenüberliegenden Seiten des Schirms angeordnet und verteilt ist, daß einer ersten Untergruppe der zwischen den beiden Seiten miteinander verbundenen Bereiche die spezifische Untergruppe Ei entspricht, die ein und nur ein Plättchen pro Baum des Mustertyps des zu prüfenden gedruckten Schaltkreises enthält, und daß der zweiten Untergruppe der zwischen den beiden Seiten miteinander verbundenen Bereiche die spezifische Untergruppe Ec entspricht, die alle anderen Plättchen des besagten zu prüfenden, gedruckten Schaltkreises enthält.

4. Vorrichtung zur Prüfung nach einen der Ansprüche 1 bis 3, dadurch gekennzeichnet, daß zum ermöglichen der selektiven Trennung der Plättchen des zu prüfenden gedruckten Schaltkreises derart, daß Ei + Ec = E ist, die Anordnung der leitenden Bereiche der Auswahlmittel so ist, daß alle zu Ei gehörenden Plättchen elektrisch mit einen gemeinsamen leitenden Bereich verbunden sind und daß alle zu Ec gehörenden Plättchen von dem besagten gemeinsamen leitenden Bereich elektrisch isoliert sind, durch einen ringförmigen Zwischenraum konstanter Breite, so daß ein als Gleitschuh ausgebildeter, zu den besagten Abtastmitteln gehörender und eine kreisförmige Gestalt besitzender Elementarleiter ($V_2$) nicht ganz in ihn hineinpaßt.

5. Vorrichtung zur Prüfung nach einen der Ansprüche 1 bis 4, dadurch gekennzeichnet, daß zum Ermöglichen einer gemeinsamen Abtastung der Außenfläche der Auswahlmittel ein beweglicher Testkreis ($V_2$) realisiert ist, der eine oder mehrere Reihen (a, b) von elementaren Gleitschuhen aufweist, deren leitende Oberfläche notwendig in die Oberfläche hineinpaßt, die durch den äußeren Rand der isolierenden Oberfläche begrenzt ist, welche jedes der Plättchen der Gruppe Ec umgibt, und die in die Oberfläche nicht ganz hineinpaßt, welche zwischen dem äußeren Rand der besagten isolierenden Oberfläche und dem äußeren Rand des besagten korrespondierenden Plättchens angeordnet ist.

6. Verfahren zur qualitativen Prüfung der elektrischen Kontinuität gedruckter Mehrschichtschaltkreise unter Verwendung der Vorrichtung nach den Ansprüchen 1 bis 5, dadurch gekennzeichnet, daß es besteht aus:
- dem durch Aufeinanderlegen Inkontaktbringen des zu prüfenden gedruckten Schaltkreises und seinen spezifischen Auswahlmitteln;
- dem coplanaren Verschieden der Abtastmittel auf der äußeren Oberfläche der besagten spezifischen Auswahlmittel bis zum Nachweis der Kontinuitätsfehler zwischen jedem der elementaren Gleitschuhe einerseits und der gemeinsamen Leiterfläche andererseits.

## Claims

1. Device for controlling qualitatively the electrical continuity of multiple equipotential branches - or "trees"forming the conductor network of multiale layer printed circuits of the conventional or hybrid type, characterised in that it comprises:
- specific selector means for selecting a determined design-type of printed circuit to be controlled, adapted for, by superposition with the latter, selecting two distinct subassemblies Ei and Ec, electrically predefined so that E = Ei + Ec, among the assembly E of the conductor elements - or "chips" - accessible on at least one of the outer faces of said printed circuit to be controlled ;
- explorator means for exploring said specific selector means for, by displacements in contact with the latters, detecting the continuity defects in the conductor network of the printed circuit to be controlled ;

- indicator means for indicating the qualitative state of the electrical continuity within the different branches of said trees.

2. Control device of claim 1, characterized in that said selector means and explorator means comprise a supple screen of metallized insulating material comprising, extended over each of its opposite faces, a coplanar arrangement of conducting areas mutually insulated on a same face and interconnected from one face to the other via metallized holes.

3. Control device of claim 2, characterized in that the assembly E of the conducting areas of the selector means is adapted and extends over the two opposite faces of the screen such that to a first subassembly of areas interconnected between the two faces corresponds the specific subassembly Ei comprising a chip and only one per tree of the design-type of printed circuit to be controlled and that to the second subassembly of areas interconnected between the two faces corresponds the specific subassembly Ec comprising all other chips of said printed circuit to be controlled.

4. Control device of one of claims 1 to 3, characterized in that, in order to enable the selective separation of the chips of the printed circuit to be controlled so that Ei + Ec = E, the arrangement of the conducting areas of the selector means is such that all chips belonging to Ei are electrically connected to a common conducting area and all chips belonging to Ec are electrically insulated from said common conductive area by an annular space of constant width, such that an elementary conductive slipper element ($V_2$), belonging to said explorator means and of circular shape, cannot be entirely inscribed therein.

5. Control device of one of claims 1 to 4, characterized in that, in order to enable the collective exploration of the external face of the selector means, a mobile test circuit ($V_2$) is realised comprising one or several rows (a, b) of elementary slipper elements of which the conductive surface is necessarily inscribed in the surface defined by the outer edge of the insulating surface surrounding each chip of the assembly Ec and cannot be entirely inscribed in the surface included between the outer edge of said insulating surface and the outer edge of said corresponding chip.

6. Process for controlling qualitatively the electrical continuity of multiple layer printed circuits, using the device of the claims 1 to 5 and characterized in that it comprises the steps of :
- moving into contact, by superposition, the printed circuit to be tested with its specific selector means ;
- displacing in a coplanar way the explorator means on the external face of said specific selector means, in order to detect the continuity defects between each elementary slipper element of the one and the common conductive plane of the other.

Fig.1

Fig.2

Fig.3